# FASCICULE DE BREVET EUROPEEN

(11) **EP 3 895 220 B1**
(45) Date de publication et mention de la délivrance du brevet: **16.11.2022**
(21) Numéro de dépôt: 19842599.3
(22) Date de dépôt: 11.12.2019
(51) Int. Cl.: H01L 31/042, H01L 31/048

(54) **PROCEDE D'ASSEMBLAGE DE CELLULES PHOTOVOLTAÏQUES A UN SUBSTRAT IMPREGNE DE MATERIAU POLYMERE RETICULABLE**
VERFAHREN ZUR BINDUNG VON FOTOVOLTAISCHEN ZELLEN AN EIN MIT VERNETZBAREM POLYMERMATERIAL IMPRÄGNIERTES SUBSTRAT
METHOD FOR BINDING PHOTOVOLTAIC CELLS TO A SUBSTRATE IMPREGNATED WITH CROSSLINKABLE POLYMER MATERIAL

(30) Priorité: 13.12.2018 FR 1872843
(43) Date de publication de la demande: 20.10.2021
(73) Titulaire: Commissariat à l'Energie Atomique et aux Energies Alternatives, 75015 Paris (FR)
(72) Inventeur: BARBOT, Anthony, 38054 GRENOBLE cedex 09 (FR); ROUJOL, Yannick, 38054 GRENOBLE cedex 09 (FR); SERAINE, Caroline, 38054 GRENOBLE cedex 09 (FR)
(74) Mandataire: INNOV-GROUP
(86) Numéro de dépôt international: PCT/FR2019/053025
(87) Numéro de publication internationale: WO 2020/120907

(56) Documents cités:
- US-A- 5 298 085
- US-B2- 9 842 952

## Description

### Domaine technique de l'invention

Le domaine technique de l'invention concerne l'assemblage de cellules photovoltaïques à un substrat, notamment pour former un module photovoltaïque, par exemple du type à être déployé dans l'espace. En particulier, l'invention est relative à un procédé d'assemblage de cellules photovoltaïques à un substrat, chaque cellule photovoltaïque comportant une face arrière et une face avant.

### Etat de la technique

Dans le domaine spatial, il est connu d'utiliser des cellules photovoltaïques interconnectées et encapsulées individuellement à l'aide d'un élément de protection individuel aussi appelé « cover glass ». Ces cellules photovoltaïques sont appelées cellules solaires encapsulées ou CICs (« pour cover glass interconnected solar cells » en langue anglaise). Ces cellules photovoltaïques sont collées sur un substrat rigide, ou flexible (c'est-à-dire souple), par exemple à l'aide de silicone. L'utilisation d'un substrat flexible est avantageux dans le cadre de la fabrication d'un module photovoltaïque pouvant être déployé dans l'espace. Pour réaliser le collage, le dépôt de silicone sur le substrat est habituellement réalisé selon un motif particulier à l'aide d'un robot dit « de collage » avant de poser les cellules photovoltaïques sur le silicone déposé, puis de solliciter les cellules photovoltaïques (notamment par pression exercée sur ces dernières) vers le substrat jusqu'à réticulation complète du silicone.

Le dépôt du silicone par le robot de collage sur le substrat présente les inconvénients suivants :
- la quantité de silicone utilisée et le motif réalisé doivent être correctement ajustés, ceci complexifie le procédé d'assemblage des cellules photovoltaïques au substrat,
- des bulles de gaz, notamment d'air, formées lors du dépôt du silicone peuvent rester emprisonnées dans le silicone réticulé, ceci présente un risque quant à la fiabilité du module photovoltaïque dans le sens où la présence de bulles de gaz peut provoquer une dégradation du module photovoltaïque, par exemple son explosion, lorsque ce dernier est déployé dans l'espace.

La demande de brevet US2017/0301811 décrit l'assemblage d'une cellule solaire à un support flexible à l'aide d'un adhésif. L'adhésif est déposé sur le support flexible ou sur la face arrière de la cellule solaire. Un tel assemblage présente l'inconvénient de favoriser la présence de bulles de gaz dans l'adhésif.

La demande de brevet US2011/0290304 décrit un module photovoltaïque comportant un substrat textile. Ce substrat textile comporte des conducteurs. Des tuiles solaires du module photovoltaïque sont en contact chacune avec au moins un conducteur. Le textile et les tuiles solaires peuvent ensuite être encapsulées à l'aide d'une résine silicone liquide. Une telle encapsulation présente l'inconvénient de favoriser la présence de bulles de gaz dans l'encapsulant.

Il est connu le brevet américain US 9,842,952 B2 concernant un procédé pour former une matrice photovoltaïque en utilisant une composition de silicone liquide et un tapis en textile non-tissé. Le tapis est au moins partiellement enduit par la composition de silicone liquide après ou simultanément au dépôt de la composition de silicone liquide sur des cellules photovoltaïques.

Il est connu le brevet américain publié sous le numéro 5,298,085 concernant des cellules solaires adhérant à un tissu à l'aide de silicone durci.

### Objet de l'invention

L'invention a pour but de proposer un procédé d'assemblage plus simple à mettre en œuvre, notamment en évitant l'ajustement du motif et de la quantité du matériau à utiliser pour coller les cellules photovoltaïques au substrat. De préférence, ce procédé est adapté pour la formation d'un module photovoltaïque destiné à être utilisé dans l'espace.

A cet effet, l'invention est relative à un procédé d'assemblage de cellules photovoltaïques à un substrat, chaque cellule photovoltaïque comportant une face arrière et une face avant, le procédé d'assemblage comportant : la fourniture du substrat, ledit substrat étant souple et imprégnable, l'imprégnation de portions du substrat par un matériau polymère réticulable, lesdites portions étant imprégnées selon l'épaisseur du substrat, pour coller les cellules photovoltaïques au substrat, la mise en contact des faces arrière des cellules photovoltaïques avec les portions imprégnées du substrat, la réticulation du matériau polymère réticulable, une étape de lamination du substrat et des cellules photovoltaïques assurant la réticulation du matériau polymère réticulable, les cellules photovoltaïques mises en contact avec les portions imprégnées du substrat étant interconnectées et comportant chacune un élément de protection individuel formant sa face avant.

Un tel procédé d'assemblage permet de coller les cellules photovoltaïques au substrat sans avoir à se préoccuper de réaliser des motifs particuliers en matériau polymère réticulable puisque le substrat est imprégné, au moins via ses portions destinées à être en contact avec les cellules photovoltaïques, par le matériau polymère réticulable. Par ailleurs, l'imprégnation par le matériau polymère réticulable permet d'obtenir, après réticulation du matériau polymère réticulable, un lien plus intime des cellules photovoltaïques avec un support notamment composé d'une matrice en matériau polymère réticulé dans laquelle est intégré le substrat, les cellules photovoltaïques étant collées à ce support.

Le procédé d'assemblage peut en outre comporter une ou plusieurs des caractéristiques suivantes :
- chaque portion imprégnée du substrat présente une surface dont une partie seulement est en contact avec la face arrière de la cellule photovoltaïque mise en contact avec ladite portion imprégnée du substrat ;
- au cours de l'étape de lamination : les faces avant des cellules photovoltaïques sont orientées vers une table d'un laminateur ; une nappe molle est agencée entre les cellules photovoltaïques et la table du laminateur ; un rapprochement de chacune des cellules photovoltaïques vers la table du laminateur provoque une formation d'enfoncements dans la nappe molle ;
- le procédé d'assemblage comporte la formation d'un empilement comprenant successivement, du bas de l'empilement vers le haut de l'empilement, un premier support rigide, le substrat dont les portions sont imprégnées par le matériau polymère réticulable, les cellules photovoltaïques, la nappe molle, un deuxième support rigide, et le procédé d'assemblage est tel que : le deuxième support est placé sur la table du laminateur ; l'étape de lamination assure la lamination de l'empilement dépourvu du premier support ; au terme de l'étape de lamination, les cellules photovoltaïques sont collées chacune au substrat par du matériau polymère réticulé ;
- pour imprégner les portions, la formation de l'empilement comporte successivement : la formation d'une couche de matériau polymère réticulable ; la mise en contact d'une première face du substrat avec la couche de matériau polymère réticulable ; l'ajout de matériau polymère réticulable sur une deuxième face du substrat opposée à la première face du substrat ; le lissage du substrat pour homogénéiser l'imprégnation des portions du substrat par le matériau polymère réticulable ;
- le matériau polymère réticulable est choisi parmi la famille des silicones ;
- le substrat est un tissu ;
- le tissu est choisi parmi : un tissu de fibres de verre, un tissu de fibres d'aramide et un tissu de polyester aromatique ;
- le grammage du tissu est compris entre 20 g/m² et 300 g/m² ;
- la mise en contact des faces arrière des cellules photovoltaïques avec les portions imprégnées du substrat est réalisée après l'imprégnation des portions du substrat par le matériau polymère réticulable.

D'autres avantages et caractéristiques relatifs à l'invention ressortiront clairement de la description détaillée qui va suivre.

### Description sommaire des dessins

L'invention sera mieux comprise à la lecture de la description détaillée qui va suivre, donnée uniquement à titre d'exemple non limitatif et faite en se référant aux dessins annexés et listés ci-dessous.
La figure 1 illustre une vue en perspective d'un module photovoltaïque obtenu par un procédé d'assemblage selon la présente invention.
La figure 2 est une vue en coupe selon une coupe A-A de la figure 1.
La figure 3 illustre une vue en perspective d'un substrat comportant des portions imprégnées par un matériau polymère réticulable.
La figure 4 illustre une vue en coupe, parallèle à l'épaisseur du substrat, d'une partie d'une portion imprégnée du substrat de la figure 3.
La figure 5 illustre, selon une vue en coupe, un empilement à laminer placé dans un laminateur.
La figure 6 illustre, selon une vue en coupe, une étape de lamination selon un mode de réalisation particulier du procédé d'assemblage selon la présente invention.
La figure 7 illustre une vue en coupe du module photovoltaïque pouvant être obtenu au terme de l'étape de lamination.
La figure 8 illustre une vue en coupe d'un empilement, selon un mode de réalisation particulier du procédé d'assemblage, réalisé avant la mise en œuvre de l'étape de lamination.
La figure 9 illustre, selon une vue en coupe, l'empilement de la figure 8 placé dans le laminateur.
La figure 10 illustre, selon une vue en coupe, une variante de la figure 5 pour laquelle l'empilement à laminer placé dans le laminateur comporte des adhésifs.
La figure 11 illustre une vue en coupe du module photovoltaïque, selon une réalisation pour laquelle il est pliable, en cours de pliage.
La figure 12 illustre, selon une vue en coupe, une étape selon une réalisation du procédé d'assemblage.
La figure 13 illustre, selon une vue en coupe, une étape selon une réalisation du procédé d'assemblage.
La figure 14 illustre un exemple particulier de cellule photovoltaïque, vue en coupe, à coller au substrat selon la présente invention.

Dans ces figures, les mêmes références sont utilisées pour désigner les mêmes éléments.

### Description détaillée

Dans la présente description, une valeur comprise entre deux bornes s'entend bornes incluses.

Classiquement, une cellule photovoltaïque présente deux faces opposées respectivement appelées face avant et face arrière. La face avant de la cellule photovoltaïque est une face configurée pour recevoir un rayonnement, notamment solaire, à convertir en énergie électrique. Notamment, chaque cellule photovoltaïque du module photovoltaïque décrit ci-après présente une épaisseur comprise entre 10 micromètres et 300 micromètres.

De préférence, les cellules photovoltaïques visées dans la présente description sont des cellules solaires encapsulées ou CICs (« pour cover glass interconnected solar cells » en langue anglaise). Autrement dit, il s'agit de cellules photovoltaïques interconnectées et comportant chacune un élément individuel de protection réalisant l'encapsulation de ladite cellule photovoltaïque en face avant.

Dans la présente description, par « à base de », on entend « comporte au moins majoritairement ». En ce sens, dans le cadre « d'un élément à base d'un matériau », « à base de » peut aussi désigner « est constitué par », notamment si le matériau concerné est le seul à entrer dans la composition dudit élément.

Dans la présente description, les termes « espace » ou « spatial », correspondent à au-delà de l'atmosphère terrestre.

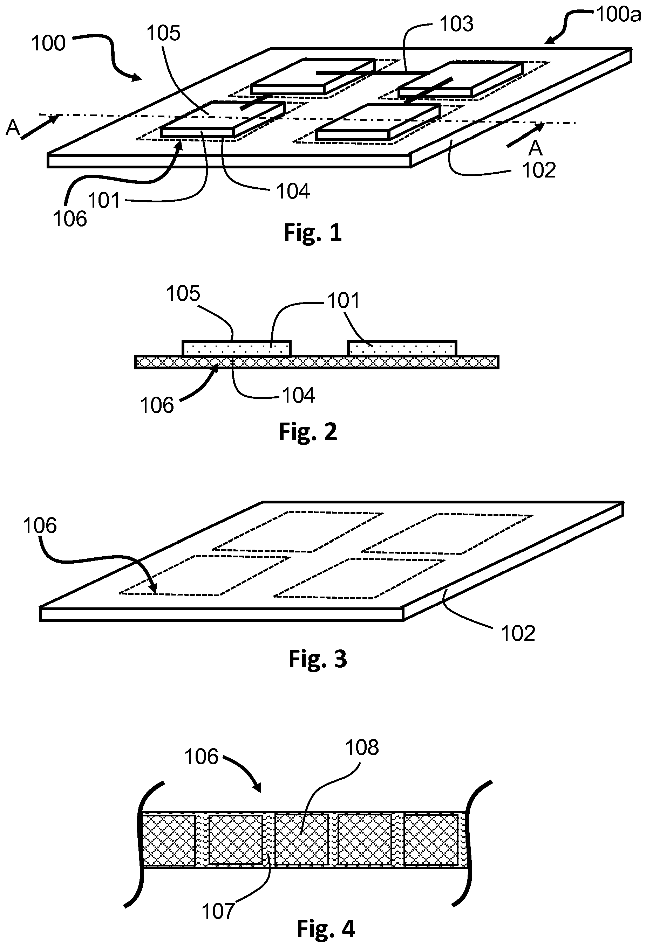

La figure 1 représente un module photovoltaïque 100 comportant des cellules photovoltaïques 101, par exemple au nombre de quatre, collées à un substrat 102 notamment par un matériau polymère réticulé. En fait, le module photovoltaïque 100 peut comporter un support 100a formé par le substrat 102 et du matériau polymère réticulé qui s'étend dans le substrat 102. Par « substrat », il est entendu ici un élément de support auquel les cellules photovoltaïques 101 sont solidarisées. Ce substrat 102 est notamment souple. Le support 100a peut être lui aussi souple de sorte à être fléchi ou plié. Les cellules photovoltaïques 101 sont notamment interconnectées par des bus de connexion électrique 103, par exemple en série comme représenté schématiquement en figure 1.

Par « substrat souple », il est entendu que le substrat 102 est flexible et peut notamment être déformé/plié que cela soit au cours d'une étape de lamination telle que décrite ci-après, ou au cours du déploiement ou du pliage du module photovoltaïque 100 comportant ce substrat 102. Cette souplesse du substrat 102 peut être conférée par un coefficient de drapé du substrat 102 compris entre 0 et 0,8, notamment lorsque le substrat 102 est un tissu. Une telle souplesse est tout particulièrement adaptée dans le cadre d'une application spatiale ou dans le cadre d'une application terrestre nomade où l'on cherche à avoir un module photovoltaïque souple/pliable.

Par « substrat imprégnable », il est entendu que le substrat permet la diffusion de matériau, notamment du matériau polymère réticulable tel que décrit ci-après en son sein.

L'invention est relative à un procédé d'assemblage de cellules photovoltaïques 101 au substrat 102, notamment pour former le module photovoltaïque 100. Chaque cellule photovoltaïque 101 comporte une face arrière 104 et une face avant 105 (figures 1 et 2). Le procédé d'assemblage comporte : la fourniture du substrat 102 (figure 3), ledit substrat 102 étant souple et imprégnable notamment par un matériau polymère réticulable ; l'imprégnation de portions 106 du substrat 102 (notamment ces portions 106 du substrat 102 sont ci-après simplement dénommées portions 106) par le matériau polymère réticulable 107 (figures 3 et 4), lesdites portions 106 étant imprégnées selon l'épaisseur du substrat 100, pour coller (c'est-à-dire en vue de coller) les cellules photovoltaïques 101 au substrat 102 (les portions 106 imprégnées sont donc destinées à coller les cellules photovoltaïques 101 au substrat 102) ; la mise en contact des faces arrière 104 des cellules photovoltaïques 101, notamment interconnectées entre elles, avec les portions 106 imprégnées du substrat 102 (figures 1 à 4, les portions 106 sont représentées en pointillé en figures 1 et 3) ; la réticulation du matériau polymère réticulable 107 d'où il résulte le collage des cellules photovoltaïques 101 au substrat 102. Au contraire du collage classique utilisant un robot de collage, le procédé d'assemblage selon la présente invention permet, grâce à l'imprégnation des portions 106 du substrat 102, d'obtenir des zones privilégiées pour fixer les cellules photovoltaïques 101 au substrat 102 ne nécessitant pas la réalisation de motifs adaptés complexes : il en résulte une simplification de la mise en œuvre du procédé d'assemblage ainsi qu'une réalisation plus rapide contrairement à l'optimisation laborieuse du dépôt de silicone et de la pression exercée selon ce qui est décrit dans la partie état de la technique. Notamment, au terme de la réticulation du matériau polymère réticulable 107, le substrat 102 et le matériau polymère réticulé forment le support 100a appartenant au module photovoltaïque 100 auquel sont fixées les cellules photovoltaïques 101 (figure 1). Ce support 100a est alors, de préférence, composé d'une matrice en matériau polymère réticulé intégrant en tout ou partie le substrat 102. Par la suite, la formulation « imprégnation du substrat 102 » ou « substrat 102 imprégné » englobe tout aussi bien l'imprégnation (et plus particulièrement le résultat de l'imprégnation) des portions 106 par le matériau polymère réticulable 107 et par exemple de seulement ces portions 106, ou de l'intégralité du substrat 102 par le matériau polymère réticulable 107 (ou le cas échéant réticulé). Autrement dit, le procédé d'assemblage comporte notamment l'imprégnation d'au moins les portions 106 du substrat 102. Selon une autre formulation, le procédé d'assemblage peut comporter l'imprégnation du substrat 102 notamment d'où il résulte l'imprégnation de seulement les portions 106 du substrat 102 ou l'imprégnation de l'intégralité du substrat 102 comprenant alors les portions 106 imprégnées destinées à coller les cellules photovoltaïques 101. Par ailleurs, grâce à l'imprégnation du substrat 102 par le matériau polymère réticulable 107, il est obtenu un lien plus intime entre les cellules photovoltaïques 101 et le support 100a du module photovoltaïque 100. Ce procédé d'assemblage permet aussi grâce à l'imprégnation du substrat 102 par le matériau polymère réticulable 107, et de préférence en combinaison avec l'étape de lamination décrite ci-après, un meilleur dégazage de bulles de gaz (par exemple d'air) formées au sein du matériau polymère réticulable 107 imprégnant le substrat 102.

L'imprégnation des portions 106 par le matériau polymère réticulable 107 selon l'épaisseur du substrat 102 permet au matériau polymère réticulable 107 de se répandre de façon diffuse, c'est-à-dire uniforme, dans les portions 106. Notamment, on dit alors que les portions 106 sont intégralement imprégnées par le matériau polymère réticulable 107. Ceci permet de limiter la présence de bulles de gaz au sein du matériau polymère réticulé obtenu par réticulation du matériau polymère réticulable 107. Par exemple, la figure 4 représente une vue en coupe d'une partie d'une portion 106 imprégnée du substrat 102 par le matériau polymère réticulable 107, ce matériau polymère réticulable 107 étant notamment présent entre des fils 108 du substrat 102 lorsque ce dernier est un tissu. Par imprégnation selon l'épaisseur du substrat 102, il est entendu que le matériau polymère réticulable 107 est présent au sein de ladite portion 106 selon toute son épaisseur.

Notamment, chaque portion 106 imprégnée du substrat 102 présente une surface dont une partie seulement est en contact avec la face arrière 104 de la cellule photovoltaïque 101 mise en contact avec ladite portion 106 imprégnée du substrat 102. Autrement dit, chaque portion 106 déborde latéralement à la périphérie de la cellule photovoltaïque 101 avec laquelle ladite portion 106 est en contact. Ceci présente l'avantage d'assurer un collage adéquat de chaque cellule photovoltaïque 101 pour éviter le risque de décollement et l'avantage de permettre une dissipation thermique homogène sous ladite cellule photovoltaïque 101. Si l'imprégnation du substrat 102 est réalisée uniquement au niveau de chaque portion 106 pour des dimensions égales à la dimension de la face arrière 104 de la cellule photovoltaïque 101 à coller, cela complexifierait le procédé d'assemblage en demandant une grande précision lors du positionnement des cellules photovoltaïques 101 sur le substrat 102.

En particulier, la mise en contact des faces arrière 104 des cellules photovoltaïques 101 avec les portions 106 imprégnées du substrat 102 est réalisée après l'imprégnation des portions 106 du substrat 102 par le matériau polymère réticulable 107.

Par « matériau polymère réticulable 107 », il est entendu « matériau polymère apte à être réticulé ».

Le matériau polymère réticulable 107 est, de préférence, à l'état liquide. Par « matériau polymère réticulable à l'état liquide », il est entendu que le matériau polymère réticulable 107 a tendance à couler en raison de la faible cohésion des molécules qui le compose. Notamment, l'état liquide du matériau polymère réticulable 107 correspond à un matériau polymère dont la viscosité est préférentiellement comprise entre 1 Pa.s et 50 Pa.s à une température de 25°C. Dans la présente description, les valeurs de viscosité sont données à la pression atmosphérique. De telles valeurs de viscosité permettent d'imprégner de manière convenable le substrat 102. En particulier, la viscosité du matériau polymère réticulable peut être strictement supérieure à 5 Pa.s à une température de 25°C et être inférieure ou égale à 50 Pa.s à une température de 25°C, de préférence cette viscosité est strictement supérieure à 5 Pa.s à une température de 25°C et est inférieure ou égale à 10 Pa.s à une température de 25°C.

Le matériau polymère réticulable 107 est notamment un matériau polymère dont la réticulation est strictement inférieure à son point de gel. Le point de gel d'un matériau polymère se caractérise par une augmentation brutale de la viscosité complexe de ce matériau polymère et du module de cisaillement complexe de ce matériau polymère. Au point de gel et au-delà, un réseau tridimensionnel se forme et les chaînes de ce matériau polymère ne peuvent plus glisser les unes sur les autres.

De préférence, dans la présente description tout matériau polymère évoqué, qu'il soit réticulé ou réticulable, peut être choisi parmi la famille des silicones aussi appelée famille des polysiloxanes. Un tel matériau est tout particulièrement adapté pour coller les cellules photovoltaïques 101 au substrat 102 notamment pour une application dans le domaine spatial. Par la suite, le silicone est défini par un polymère choisi parmi la famille des silicones.

Par ailleurs, le matériau polymère réticulable peut aussi comporter des additifs pour éviter qu'il ne jaunisse après sa réticulation.

Il résulte de ce qui a été décrit ci-dessus que le substrat 102 est poreux de sorte à permettre son imprégnation (notamment d'au moins ses portions 106) par le matériau polymère réticulable 107. En ce sens, le substrat 102 fourni est dit imprégnable par le matériau polymère réticulable 107 ou perméable au matériau polymère réticulable 107. Notamment, cette perméabilité permet l'imprégnation du silicone dans le substrat 102 lorsque ce dernier est un tissu comme cela sera décrit par la suite.

Selon une réalisation, le substrat 102 peut être entièrement imprégné par le matériau polymère réticulable 107 avant que les faces arrière 104 des cellules photovoltaïques 101 ne soient mises en contact avec ce substrat 102 imprégné. Ceci présente l'avantage de protéger l'intégralité du substrat 102 par du matériau polymère réticulé au terme de la réticulation du matériau polymère réticulable 107 : le substrat 102 se retrouve alors enrobé par du matériau polymère réticulé.

De préférence, le substrat 102 est un substrat tissé : le substrat est un tissu. Le tissu présente l'avantage d'être facilement imprégné par pénétration du matériau polymère réticulable 107 dans les mailles du tissu (entre ses fils 108 en figure 4), et présente l'avantage d'avoir une souplesse adéquate.

De préférence, le grammage du tissu est compris entre 20 g/m² et 300 g/m². Ceci permet notamment d'assurer la souplesse recherchée du tissu, en particulier lorsqu'il est imprégné et, le cas échéant, du tissu après réticulation du matériau polymère réticulable 107 utilisé pour l'imprégner.

Un tel tissu peut être choisi parmi un tissu de fibres de verre, un tissu de fibres d'aramide comme le Kevlar^{®} (le Kevlar^{®} correspondant à du poly(p-phénylènetéréphtalamide) aussi appelé PPD-T) ou comme le Twaron^{®} correspondant à un p-phénylène téréphtalamide (PpPTA), et un tissu de polyester aromatique tel que le Vectran^{®}. Ces tissus sont tout particulièrement adaptés pour y coller les cellules photovoltaïques tout en conservant une souplesse après réticulation du matériau polymère réticulé collant les cellules photovoltaïques 101 au tissu.

De manière générale, le substrat 102 présente un grammage compris entre 20 g/m² et 300 g/m², ceci lui conférant une légèreté tout particulièrement adaptée au domaine spatial ou dans le cadre d'une application terrestre nomade.

De préférence, comme évoqué ci-dessus, le matériau polymère réticulable 107 comporte du silicone ou est à base de silicone. Le matériau polymère réticulable 107 peut comporter, notamment être constitué de, deux composants A et B. Le composant A est une base, par exemple de type PDMS (pour polydiméthylsiloxane). Le composant B contient un agent vulcanisant, comme par exemple un polysiloxane, et un catalyseur pour permettre aux chaînes de polymère de se ramifier pour former un réseau tridimensionnel de sorte que le matériau polymère réticulable 107 puisse, au terme de sa réticulation, former un matériau polymère solide et infusible dit « réticulé ». Les avantages du silicone sont : qu'il s'agit d'un matériau polymère tout particulièrement adapté pour le domaine spatial ; qu'il s'agit d'un bon isolant électrique ; que le silicone présente une stabilité environnementale lui procurant une résistance aux acides, à l'oxygène et à l'humidité ; que le silicone ne se dégrade pas ou peu à des températures allant de -200°C à 200°C ; que le silicone protège le substrat 102 des rayonnements ultraviolets ; que le silicone permet aussi d'améliorer les propriétés mécaniques du substrat 102, notamment lorsque ce dernier est un tissu.

Le matériau polymère réticulable 107 peut être une formulation de silicone de type Sylgard ^{®} 184, ou de DOW CORNING^{®}93-500, ou encore une colle silicone RTV-S 691 de la société Wacker.

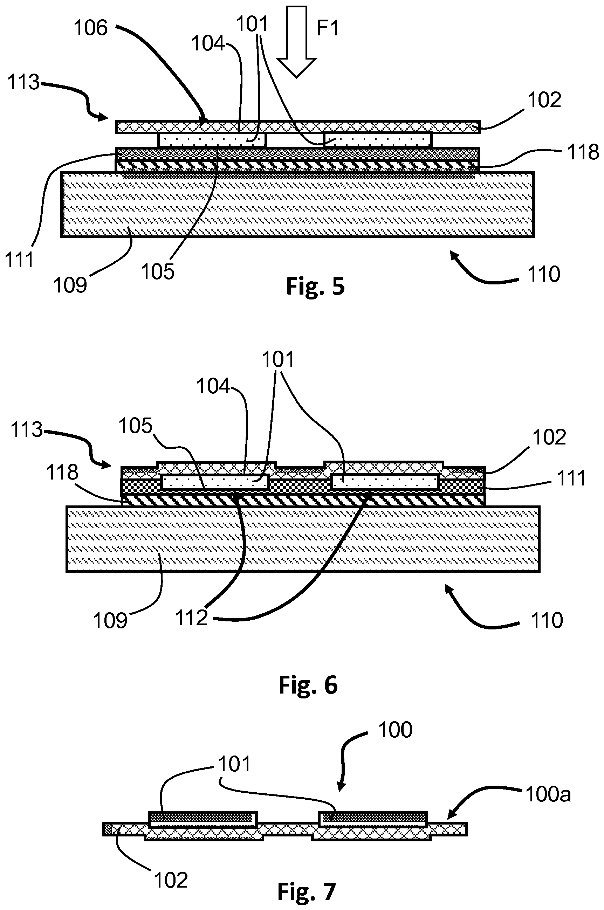

De préférence, le procédé d'assemblage comporte une étape de lamination (figures 5 et 6) du substrat 102 et des cellules photovoltaïques 101 assurant la réticulation du matériau polymère réticulable 107 : le matériau polymère réticulable 107 passe alors à un état réticulé au cours de l'étape de lamination. Autrement dit, l'étape de lamination permet de mettre en œuvre la réticulation. La flèche F1 de la figure 5 montre que la lamination va tendre à solliciter les cellules photovoltaïques 101 en direction d'une table 109 d'un laminateur 110. L'étape de lamination permet d'améliorer le collage des cellules photovoltaïques 101 au substrat 102. En effet, l'étape de lamination permet de comprimer le substrat 102 avec les cellules photovoltaïques 101 pour assurer une mise en contact adéquate de la face arrière 104 de chacune des cellules photovoltaïques 101 avec le substrat 102. Avantageusement, l'étape de lamination permet d'éviter la présence de bulles de gaz au sein du matériau polymère réticulé obtenu par réticulation du matériau polymère réticulable 107.

L'étape de lamination est notamment réalisée sous vide, par exemple à 1 mbar, à chaud par exemple entre 60°C et 150°C, et pendant une durée adaptée à la réticulation par exemple comprise entre 10 min et 240 min. La réalisation de l'étape de lamination sous vide permet de retirer des bulles de gaz présentes dans le matériau polymère réticulable 107 imprégnant le substrat 102 et notamment ses portions 106. La réalisation de l'étape de lamination à chaud permet d'assurer la réticulation du matériau polymère réticulable 107 en une durée limitée. En ce sens, cette étape de lamination est adaptée en durée, en pression, et en température pour réticuler le matériau réticulable.

De préférence, comme par exemple visible en figures 5 et 6, au cours de l'étape de lamination : les faces avant 105 des cellules photovoltaïques 101 sont orientées vers la table 109 du laminateur 110 dans lequel est réalisé l'étape de lamination ; une nappe 111 molle (aussi appelée nappe souple) est agencée entre les cellules photovoltaïques 101 et la table 109 du laminateur 110; un rapprochement de chacune des cellules photovoltaïques 101 vers la table 109 du laminateur 110 (passage de la figure 5 à la figure 6) provoque une formation d'enfoncements 112 dans la nappe 111 molle. Autrement dit, l'étape de lamination permet la lamination d'un empilement comportant la nappe 111 molle, les cellules photovoltaïques 101 et le substrat 102 imprégné. Ceci présente l'avantage de limiter le relief de la face du substrat 102 opposée aux cellules photovoltaïques 101 au terme de la lamination et donc de la réticulation du matériau polymère réticulable 107. Le matériau polymère réticulable 107, notamment le silicone, imprégnant le substrat 102 aura tendance à migrer vers le bas par gravité lors de la lamination, si le relief autour des cellules photovoltaïques 101 est trop important il peut être observé visuellement que le substrat 102 en périphérie de chacune des cellules photovoltaïques 101 s'est déchargé du matériau polymère réticulable 107 au cours de la lamination. En ce sens, la nappe 111 molle permet aux cellules photovoltaïques 101 de s'enfoncer dans cette nappe 111 molle de sorte que, au cours de la lamination, le substrat 102 adopte une forme plus plane que si la nappe 111 molle n'était pas présente, ceci permettant de limiter les inhomogénéités liées au déchargement du matériau polymère réticulable 107 évoqué dans le présent paragraphe.

La nappe 111 molle peut être en silicone et présenter une épaisseur comprise entre 0,3 mm et 5 mm. Une telle nappe 111 molle peut présenter une dureté comprise entre 10 et 50 sur l'échelle Shore A. Ces caractéristiques de la nappe 111 molle permettent d'obtenir la déformation souhaitée de cette dernière, au cours de l'étape de lamination, par enfoncement des cellules photovoltaïques 101 dans la nappe 111 molle d'où il résulte la formation des enfoncements 112.

Au terme de l'étape de lamination, les cellules photovoltaïques 101 sont collées au substrat 102, à la manière de ce qui est illustré en figure 7, par le matériau polymère réticulé obtenu par réticulation du matériau polymère réticulable 107 (non visible en figure 7).

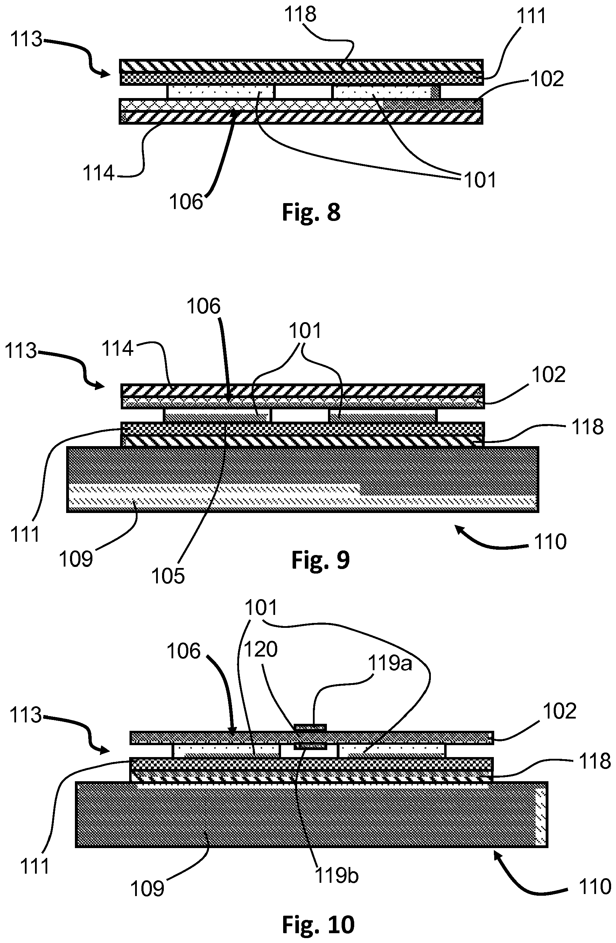

Selon un mode de réalisation particulier, notamment tel qu'illustré en figures 5, 6 et 8 à 10, le procédé d'assemblage comporte la formation d'un empilement 113 comprenant successivement (notamment du bas vers le haut de l'empilement 113 en figure 8 pour faciliter l'imprégnation du substrat 102 et notamment de ses portions 106 comme il le sera vu par la suite) un premier support 114 rigide, le substrat 102 dont les portions 106 sont imprégnées par le matériau polymère réticulable 107, les cellules photovoltaïques 101 notamment agencées de manière coplanaires et interconnectées entre elles, la nappe 111 molle, un deuxième support 118 rigide. L'empilement 113 ainsi formé peut être retourné avant de retirer le premier support 114 rigide. Le deuxième support 118 est placé sur la table 109 du laminateur 110 (figure 9), notamment avant de retirer le premier support 114 rigide (passage de la figure 9 à la figure 5). L'étape de lamination assure la lamination de l'empilement 113 dépourvu du premier support 114. Autrement dit, l'étape de lamination est mise en œuvre par le laminateur 110 en laminant l'empilement 113 dépourvu du premier support 114 (figure 6). Au terme de l'étape de lamination, les cellules photovoltaïques 101 sont collées chacune au substrat 102 (figure 7) par du matériau polymère réticulé. Les cellules photovoltaïques 101 collées au substrat 102 peuvent être récupérées à partir de l'empilement 113 de la figure 6. Cet empilement 113 particulier, notamment après retrait du premier support 114, est tout particulièrement adapté pour limiter le relief de la face du substrat 102, et donc du support 100a du module photovoltaïque 100 (figure 7), opposée aux cellules photovoltaïques 101.

Dans cet empilement 113, les éléments empilés le sont notamment selon leur épaisseur qui peut donc être mesurée parallèlement à la direction d'empilement de l'empilement 113.

Ce mode de réalisation particulier peut comporter une étape de formulation du silicone formant le matériau polymère réticulable à utiliser pour imprégner le substrat 102. Cette étape de formulation peut comporter une étape de pesée des composants A et B du silicone utilisé pour respecter le ratio souhaité entre les composants A et B. Par exemple, il faut compter au moins 100 g de silicone par mètre carré de substrat 102 à imprégner si ce dernier est un tissu de fibres de verre de 100 g/m². Cette quantité minimale peut varier en fonction du tissu à imprégner (épaisseur, densité des mailles, tension de surface). Les composants A et B sont ensuite mélangés pour homogénéiser la formulation préparée, par exemple à l'aide d'un mélangeur planétaire. De préférence, les composants A et B une fois mélangés sont dégazés dans une cloche à vide par exemple sous vide primaire de 1 mbar à 10⁻³ mbar pendant environ 10 minutes, ceci permet de former à partir des bulles présentes dans le mélange, une mousse participant à l'homogénéisation du mélange des composants A et B. Ce temps de dégazage peut varier en fonction de la quantité de formulation à dégazer et de sa nature. Il est également possible d'utiliser un mélangeur planétaire pour mélanger et/ou dégazer le silicone formé par le mélange des composants A et B.

Dans l'empilement 113, les premier et deuxième supports 114, 118 rigides ont notamment pour fonction de faciliter la manipulation de l'empilement 113 avant l'étape de lamination, et notamment de permettre son retournement (passage de la figure 8 à la figure 9) après sa formation. La rigidité de ces premier et deuxième support 114, 118 est notamment adaptée pour réaliser cette fonction : il ne se déforment pas lors de la manipulation de l'empilement 113. Par ailleurs, la rigidité du deuxième support 118 est telle que ce dernier n'est pas déformé au cours de l'étape de lamination. Les premier et deuxième support 114, 118 peuvent être chacun une plaque de verre, par exemple d'épaisseur comprise entre 1 mm et 5 mm.

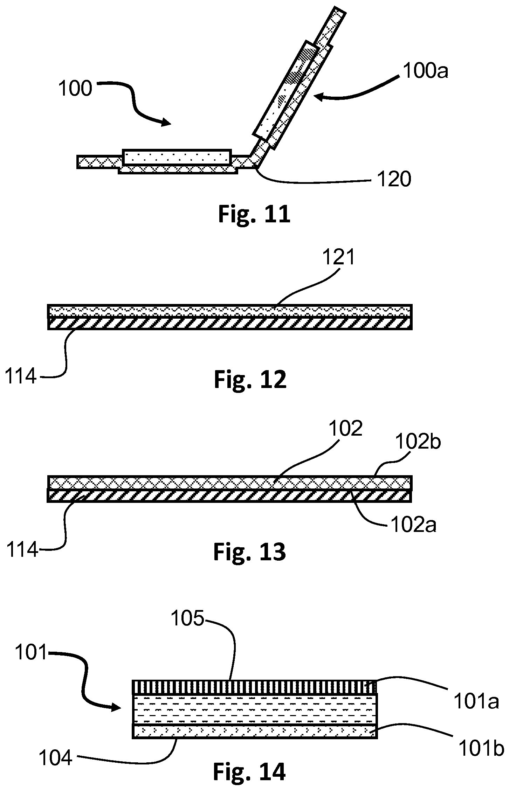

Éventuellement, avant son imprégnation par le matériau polymère réticulable 107, le substrat 102 est localement protégé par des rubans adhésifs 119a, 119b pour former au moins une zone 120 préférentielle de pliage du support 100a du module photovoltaïque 100 (figures 10 et 11) dépourvue de matériau polymère réticulé. Cette protection par rubans adhésifs 119a, 119b est aussi appelée masquage. Le rôle des rubans adhésifs 119a, 119b est de former des parties du substrat 102 ne devant pas être imprégnées de matériau polymère réticulable 107. Les rubans adhésifs 119a, 119b peuvent être retirés après réticulation du matériau polymère réticulable 107, le module photovoltaïque 100 alors obtenu peut être facilement plié au niveau de la zone 120 préférentielle de pliage. L'utilisation des rubans adhésifs n'est pas forcément obligatoire si l'on souhaite obtenir un module photovoltaïque 100 pliable dans la mesure où le support 100a, formé par le substrat 102 et le matériau polymère réticulé, peut aussi être flexible/pliable en fonction du substrat 102 et du matériau polymère réticulable utilisé.

Notamment, pour imprégner le substrat 102 (et notamment les portions 106 du substrat 102), la formation de l'empilement 113 peut comporter (figures 12 et 13) successivement :
- la formation d'une couche 121 de matériau polymère réticulable (en particulier de silicone précédemment formulé) par exemple sur le premier support 114,
- la mise en contact d'une première face 102a du substrat 102 avec la couche 121 de matériau polymère réticulable, ceci permet au matériau polymère réticulable de la couche 121 de matériau polymère réticulable de pénétrer dans le substrat 102,
- l'ajout de matériau polymère réticulable sur une deuxième face 102b du substrat 102 opposée à la première face 102a du substrat 102, ceci permet d'ajouter encore du matériau polymère réticulable pour s'assurer d'une imprégnation adéquate des portions 106 du substrat 102,
- le lissage du substrat 102 pour homogénéiser l'imprégnation des portions 106 du substrat 102 par le matériau polymère réticulable 107.
En particulier, la couche 121 de matériau polymère réticulable peut être formée par enduction par exemple à l'aide d'un pinceau ou d'un vaporisateur (spray), ou par trempage sur une surface au moins équivalente aux dimensions du substrat 102 orthogonalement à son épaisseur (figure 12). Lorsque le substrat 102 est posé sur la couche 121, il en résulte que le matériau polymère réticulable de la couche 121 est absorbé par le substrat 102 (figure 13). L'ajout de matériau polymère réticulable sur la deuxième face 102b du substrat 102 peut être réalisé à l'aide d'un pinceau. Le lissage du substrat 102 peut être réalisé à l'aide d'une raclette ou d'un débulleur pour homogénéiser l'imprégnation du matériau polymère réticulable 107 sur l'ensemble du substrat 102 : le lissage correspond donc à venir racler la surface du substrat 102. Ceci présente l'avantage de réaliser l'imprégnation directement lors de la réalisation de l'empilement : il en résulte l'optimisation du procédé d'assemblage en limitant le nombre d'étapes technologiques.

Autrement dit, on comprend de ce qui est décrit ci-dessus que de manière générale pour améliorer l'imprégnation du substrat 102, l'imprégnation du substrat 102 par le matériau polymère réticulable peut être réalisée par l'apport en matériau polymère réticulable des deux côtés du substrat 102 opposés selon son épaisseur.

Après imprégnation du substrat 102, les cellules photovoltaïques 101, notamment interconnectées et préférentiellement équipées chacune d'un élément de protection individuel en face avant, peuvent être posées sur le substrat 102 imprégné avant de finaliser l'empilement 113, notamment en y positionnant la nappe molle 111 et le deuxième support 118. Enfin, l'empilement 113 peut être retourné (grâce à la présence des premier et deuxième supports 114, 118) pour placer le deuxième support 118 sur la table 109 avant de retirer le premier support 114 puis de réaliser la lamination de l'empilement 113 dépourvu de ce premier support 114.

Il est à présent décrit un exemple particulier de réalisation permettant de coller des cellules photovoltaïques 101 interconnectées et chacune équipée d'un élément de protection individuel 101a à sa face avant 105 (figure 14) sur le substrat 102 formé par un tissu en fibre de polyaramide imprégné de silicone Sylgard^{®} 184 de la société Dow Corning. Selon cet exemple, le procédé d'assemblage comporte : la découpe du substrat 102 en fibre de polyaramide de grammage valant 60 g/m² pour obtenir un carré de 40 cm par 40 cm et d'épaisseur égale à 135 micromètres ; le dépôt d'un primaire d'accroché 101b, en utilisant par exemple d'une solution de siloxanes et de silanes réactifs dans un solvant organique (comme par exemple le WACKER^{®} PRIMER G790), pour former une couche d'épaisseur comprise entre 1 micromètre et 10 micromètres, et de grammage compris entre 5 g/m² et 50 g/m², cette couche étant formée sur les cellules photovoltaïques 101 (figure 14) pour former les faces arrière 104 de ces cellules photovoltaïques 101 en vue d'améliorer l'accroche du silicone aux cellules photovoltaïques 101 lors de sa réticulation ; la préparation d'une formulation de 25 grammes de silicone Sylgrad ^{®} 184 en respectant un ratio 10 :1 pour les parties A et B respectivement ; le mélange de la formulation, puis son dégazage dans une cloche à vide pendant environ 10 minutes ; l'imprégnation du substrat 102 avec la formulation, par exemple à l'aide d'un pinceau à la manière décrite précédemment ; le raclage du substrat 102 pour homogénéiser la quantité de silicone au sein du substrat 102 ; le positionnement des cellules photovoltaïques 101 interconnectées et équipées chacune de son élément de protection individuel sur le substrat 102 imprégné ; puis le positionnement de la nappe 111 molle et du deuxième support 118 rigide, notamment en verre, pour finaliser l'empilement 113 à retourner pouvant aussi comporter le premier support 114 ; le retournement de l'empilement 113 sur la table 109 du laminateur 110, et notamment, après ce retournement et avant la lamination, le retrait du premier support 114 ; la lamination de l'empilement 113 alors réalisée, par exemple sous vide à 140°C pendant au moins 15 minutes et de préférence en appuyant sur l'empilement, pour permettre l'enfoncement des cellules photovoltaïques 101 dans la nappe 111 molle et la réticulation du matériau polymère réticulable 107 ; le nettoyage des éléments de protection individuel 101a si nécessaire en cas de fluage de matériau polymère réticulable 107 sur ces éléments de protection individuel 101a au cours de la lamination. Selon cet exemple particulier, à la fin de la lamination, non seulement, le silicone réticulé enveloppe entièrement le substrat 102, mais lie aussi fortement les cellules photovoltaïques 101 à ce substrat 102. Après réticulation, le substrat 102 et le matériau polymère réticulé forment un support du module photovoltaïque pesant 120 g/m² (dont 60 g/m² de tissu).

De manière applicable à tout ce qui a été décrit précédemment, par exemple tel que visible en figure 14, chaque cellule photovoltaïque 101 peut comporter l'élément de protection individuel 101a formant sa face avant 105: la cellule photovoltaïque 101 est alors une cellule photovoltaïque encapsulée tout particulièrement adaptée au domaine spatial. Ainsi, les cellules photovoltaïques 101 mises en contact avec les portions 106 imprégnées du substrat 102 sont préférentiellement interconnectées (c'est-à-dire reliées électriquement) et comportent préférentiellement chacune un élément de protection individuel 101a formant sa face avant 105. Une telle cellule photovoltaïque 101 à élément de protection individuel 101a peut aussi comporter des bornes de connexion pour la connecter à au moins une autre cellule photovoltaïque. La face arrière 104 de la cellule photovoltaïque 101 peut être formée par une électrode de cette cellule photovoltaïque 101. La figure 14 illustre plus en détails une telle cellule photovoltaïque 101 comportant l'élément de protection individuel 101a formant la face avant 105 de la cellule. L'élément de protection individuel 101a permet de réaliser l'encapsulation de la cellule photovoltaïque du côté de la cellule photovoltaïque adapté à la réception du rayonnement à convertir en énergie électrique. Cet élément de protection individuel 101a peut être formé par du verre borosilicate dopé au cérium et peut présenter une épaisseur comprise entre 50 micromètres et 200 micromètres. Typiquement, l'élément de protection individuel 101a est collé au reste de la cellule photovoltaïque 101 par une couche de silicone transparente de 30 micromètres à 100 micromètres d'épaisseur.

Chaque cellule photovoltaïque peut être de type III-V.

De manière applicable à tout ce qui a été décrit précédemment, chaque cellule photovoltaïque 101 peut comporter une couche 101b en primaire d'accroché formant sa face arrière 104, notamment au contact de l'électrode agencé du côté de la face arrière de la cellule photovoltaïque. Par primaire d'accroché, il est entendu un matériau favorisant l'accroche du matériau polymère réticulé issu du matériau polymère réticulable 107. Par exemple, un tel primaire d'accroché peut être tel que celui décrit précédemment (par exemple le WACKER^{®} PRIMER G790) si le matériau polymère réticulable est du silicone. L'homme du métier sera à même de choisir le bon primaire d'accroché en fonction du matériau polymère réticulable 107 à utiliser au cours du procédé d'assemblage.

Le matériau polymère réticulable 107 utilisé peut être choisi en fonction des besoins comme par exemple sa résistance aux ultraviolets ou à certaines radiations.

La présente invention trouve une application industrielle dans la fabrication de modules photovoltaïques, notamment à destination de l'industrie spatiale. Le module photovoltaïque réalisé selon le présent procédé d'assemblage est tout particulièrement adapté pour que ce module photovoltaïque soit embarqué dans un lanceur spatial avant d'être déployé dans l'espace.

## Revendications

1. Procédé d'assemblage de cellules photovoltaïques (101) à un substrat (102), chaque cellule photovoltaïque (101) comportant une face arrière (104) et une face avant (105), le procédé d'assemblage comportant :
• la fourniture du substrat (102), ledit substrat (102) étant souple et imprégnable,
• l'imprégnation de portions (106) du substrat (102) par un matériau polymère réticulable (107), lesdites portions (106) étant imprégnées selon l'épaisseur du substrat (102), pour coller les cellules photovoltaïques (101) au substrat (102),
• la mise en contact des faces arrière (104) des cellules photovoltaïques (101) avec les portions (106) imprégnées du substrat (102),
• la réticulation du matériau polymère réticulable (107),
• une étape de lamination du substrat (102) et des cellules photovoltaïques (101) assurant la réticulation du matériau polymère réticulable (107),
les cellules photovoltaïques (101) mises en contact avec les portions (106) imprégnées du substrat (102) étant interconnectées et comportant chacune un élément de protection individuel (101a) formant sa face avant (105).

2. Procédé d'assemblage selon la revendication 1, **caractérisé en ce que** chaque portion (106) imprégnée du substrat (102) présente une surface dont une partie seulement est en contact avec la face arrière (104) de la cellule photovoltaïque (101) mise en contact avec ladite portion (106) imprégnée du substrat (102).

3. Procédé d'assemblage selon l'une quelconque des revendications 1 à 2, **caractérisé en ce qu'**au cours de l'étape de lamination :
• les faces avant (105) des cellules photovoltaïques (101) sont orientées vers une table (109) d'un laminateur (110),
• une nappe (111) molle est agencée entre les cellules photovoltaïques (101) et la table (109) du laminateur (110),
• un rapprochement de chacune des cellules photovoltaïques (101) vers la table (109) du laminateur (110) provoque une formation d'enfoncements (112) dans la nappe (111) molle.

4. Procédé d'assemblage selon la revendication précédente, **caractérisé en ce qu'**il comporte la formation d'un empilement (113) comprenant successivement, du bas de l'empilement (113) vers le haut de l'empilement (113), un premier support (114) rigide, le substrat (102) dont les portions (106) sont imprégnées par le matériau polymère réticulable (107), les cellules photovoltaïques (101), la nappe (111) molle, un deuxième support rigide (118), et **en ce que** :
• le deuxième support (118) est placé sur la table (109) du laminateur (110),
• l'étape de lamination assure la lamination de l'empilement (113) dépourvu du premier support (114),
• au terme de l'étape de lamination, les cellules photovoltaïques (101) sont collées chacune au substrat (102) par du matériau polymère réticulé.

5. Procédé d'assemblage selon la revendication précédente, **caractérisé en ce que**, pour imprégner les portions (106), la formation de l'empilement (113) comporte successivement :
• la formation d'une couche (121) de matériau polymère réticulable,
• la mise en contact d'une première (102a) face du substrat (102) avec la couche (121) de matériau polymère réticulable,
• l'ajout de matériau polymère réticulable sur une deuxième face (102b) du substrat (102) opposée à la première face (102a) du substrat (102),
• le lissage du substrat (102) pour homogénéiser l'imprégnation des portions (106) du substrat (102) par le matériau polymère réticulable (107).

6. Procédé d'assemblage selon l'une quelconque des revendications précédentes, **caractérisé en ce que** le matériau polymère réticulable (107) est choisi parmi la famille des silicones.

7. Procédé d'assemblage selon l'une quelconque des revendications précédentes, **caractérisé en ce que** le substrat (102) est un tissu.

8. Procédé d'assemblage selon la revendication 7, **caractérisé en ce que** le tissu est choisi parmi : un tissu de fibres de verre, un tissu de fibres d'aramide et un tissu de polyester aromatique.

9. Procédé d'assemblage selon l'une quelconque des revendications 7 à 8, **caractérisé en ce que** le grammage du tissu est compris entre 20 g/m² et 300 g/m².

10. Procédé d'assemblage selon l'une quelconque des revendications 1 à 9, **caractérisé en ce que** la mise en contact des faces arrière (104) des cellules photovoltaïques (101) avec les portions (106) imprégnées du substrat (102) est réalisée après l'imprégnation des portions (106) du substrat (102) par le matériau polymère réticulable (107).

## Patentansprüche

1. Verfahren zur Bindung von Photovoltaikzellen (101) an ein Substrat (102), wobei jede Photovoltaikzelle (101) eine Rückseite (104) und eine Vorderseite (105) aufweist, das Bindungsverfahren aufweisend:
• das Bereitstellen des Substrats (102), wobei das Substrat (102) biegsam und imprägnierbar ist,
• das Imprägnieren von Teilbereichen (106) des Substrats (102) mit einem vernetzbaren Polymermaterial (107), wobei die Teilbereiche (106) in der Dicke des Substrats (102) imprägniert werden, um die Photovoltaikzellen (101) an das Substrat (102) zu kleben,
• das Inkontaktbringen der Rückseiten (104) der Photovoltaikzellen (101) mit den imprägnierten Teilbereichen (106) des Substrats (102),
• das Vernetzen des vernetzbaren Polymermaterials (107),
• einen Schritt des Laminierens des Substrats (102) und der Photovoltaikzellen (101), der die Vernetzung des vernetzbaren Polymermaterials (107) sicherstellt,
wobei die Photovoltaikzellen (101), die mit den imprägnierten Teilbereichen (106) des Substrats (102) in Kontakt gebracht sind, miteinander verbunden sind und jeweils ein einzelnes Schutzelement (101a) aufweisen, das ihre Vorderseite (105) bildet.

2. Bindungsverfahren nach Anspruch 1, **dadurch gekennzeichnet, dass** jeder imprägnierte Teilbereich (106) des Substrats (102) eine Fläche aufweist, von der nur ein Abschnitt mit der Rückseite (104) der Photovoltaikzelle (101) in Kontakt steht, die mit dem imprägnierten Teilbereich (106) des Substrats (102) in Kontakt gebracht ist.

3. Bindungsverfahren nach einem der Ansprüche 1 bis 2, **dadurch gekennzeichnet, dass** im Verlauf des Schritts des Laminierens:
• die Vorderseiten (105) der Photovoltaikzellen (101) einem Tisch (109) eines Laminiergeräts (110) zugewandt sind,
• eine weiche Lage (111) zwischen den Photovoltaikzellen (101) und dem Tisch (109) des Laminiergeräts (110) angeordnet ist,
• eine Annäherung jeder der Photovoltaikzellen (101) an den Tisch (109) des Laminiergeräts (110) eine Bildung von Vertiefungen (112) in der weichen Lage (111) verursacht.

4. Bindungsverfahren nach dem vorhergehenden Anspruch, **dadurch gekennzeichnet, dass** es das Bilden eines Stapels (113) aufweist, der vom unteren Teil des Stapels (113) zum oberen Teil des Stapels (113) aufeinanderfolgend einen ersten starren Träger (114), das Substrat (102), dessen Teilbereiche (106) mit dem vernetzbaren Polymermaterial (107) imprägniert sind, die Photovoltaikzellen (101), die weiche Lage (111), einen zweiten starren Träger (118) umfasst, und dadurch, dass:
• der zweite Träger (118) auf dem Tisch (109) des Laminiergeräts (110) platziert wird,
• der Schritt des Laminierens die Laminierung des Stapels (113) ohne den ersten Träger (114) sicherstellt,
• am Ende des Schritts des Laminierens die Photovoltaikzellen (101) jeweils durch vernetztes Polymermaterial an das Substrat (102) geklebt werden.

5. Bindungsverfahren nach dem vorhergehenden Anspruch, **dadurch gekennzeichnet, dass** zum Imprägnieren der Teilbereiche (106) das Bilden des Stapels (113) aufeinanderfolgend Folgendes aufweist:
• das Bilden einer Schicht (121) aus vernetzbarem Polymermaterial,
• das Inkontaktbringen einer ersten (102a) Seite des Substrats (102) mit der Schicht (121) aus vernetzbarem Polymermaterial,
• das Aufbringen von vernetzbarem Polymermaterial auf eine zweite Seite (102b) des Substrats (102) gegenüber der ersten Seite (102a) des Substrats (102),
• das Glätten des Substrats (102) zum Homogenisieren der Imprägnierung der Teilbereiche (106) des Substrats (102) mit dem vernetzbaren Polymermaterial (107).

6. Bindungsverfahren nach einem der vorhergehenden Ansprüche, **dadurch gekennzeichnet, dass** das vernetzbare Polymermaterial (107) aus der Familie der Silikone gewählt ist.

7. Bindungsverfahren nach einem der vorhergehenden Ansprüche, **dadurch gekennzeichnet, dass** das Substrat (102) ein Gewebe ist.

8. Bindungsverfahren nach Anspruch 7, **dadurch gekennzeichnet, dass** das Gewebe aus Folgendem gewählt ist: einem Glasfasergewebe, einem Aramidfasergewebe und einem Gewebe aus aromatischem Polyester.

9. Bindungsverfahren nach einem der Ansprüche 7 bis 8, **dadurch gekennzeichnet, dass** die Grammatur des Gewebes zwischen 20 g/m² und 300 g/m² beträgt.

10. Bindungsverfahren nach einem der Ansprüche 1 bis 9, **dadurch gekennzeichnet, dass** das Inkontaktbringen der Rückseiten (104) der Photovoltaikzellen (101) mit den imprägnierten Teilbereichen (106) des Substrats (102) nach der Imprägnierung der Teilbereiche (106) des Substrats (102) mit dem vernetzbaren Polymermaterial (107) durchgeführt wird.

## Claims

1. Method for binding photovoltaic cells (101) to a substrate (102), each photovoltaic cell (101) comprising a rear face (104) and a front face (105), the binding method comprising:
• providing the substrate (102), said substrate (102) being flexible and impregnable,
• impregnating portions (106) of the substrate (102) with a crosslinkable polymer material (107), said portions (106) being impregnated along the thickness of the substrate (102), with a view to bonding the photovoltaic cells (101) to the substrate (102),
• bringing the rear faces (104) of the photovoltaic cells (101) into contact with the impregnated portions (106) of the substrate (102),
• crosslinking the crosslinkable polymer material (107),
• a step of laminating the substrate (102) and the photovoltaic cells (101) ensuring the crosslinkage of the crosslinkable polymer material (107),
the photovoltaic cells (101) brought into contact with the impregnated portions (106) of the substrate (102) being interconnected and each comprising an individual protective element (101a) forming its front face (105).

2. Binding method according to Claim 1, **characterized in that** each impregnated portion (106) of the substrate (102) has a surface only part of which makes contact with the rear face (104) of the photovoltaic cell (101) brought into contact with said impregnated portion (106) of the substrate (102).

3. Binding method according to either of Claims 1 and 2, **characterized in that**, in the lamination step:
• the front faces (105) of the photovoltaic cells (101) are oriented toward a table (109) of a laminator (110),
• a soft sheet (111) is arranged between the photovoltaic cells (101) and the table (109) of the laminator (110),
• bringing each of the photovoltaic cells (101) closer to the table (109) of the laminator (110) causes recesses (112) to be formed in the soft sheet (111).

4. Binding method for according to the preceding claim, **characterized in that** it comprises forming a stack (113) comprising successively, from the bottom of the stack (113) to the top of the stack (113), a first rigid carrier (114), the substrate (102) the portions (106) of which are impregnated with the crosslinkable polymer material (107), the photovoltaic cells (101), the soft sheet (111) and a second rigid carrier (118), and **in that**:
• the second carrier (118) is placed on the table (109) of the laminator (110),
• the lamination step ensures the lamination of the stack (113) devoid of the first carrier (114),
• at the end of the lamination step, the photovoltaic cells (101) are each bonded to the substrate (102) by crosslinked polymer material.

5. Binding method according to the preceding claim, **characterized in that**, in order to impregnate the portions (106), forming the stack (113) comprises successively:
• forming a layer (121) of crosslinkable polymer material,
• bringing a first face (102a) of the substrate (102) into contact with the layer (121) of crosslinkable polymer material,
• adding crosslinkable polymer material to a second face (102b) of the substrate (102) opposite the first face (102a) of the substrate (102),
• smoothing the substrate (102) in order to increase the uniformity of the impregnation of the portions (106) of the substrate (102) with the crosslinkable polymer material (107).

6. Binding method according to any one of the preceding claims, **characterized in that** the crosslinkable polymer material (107) is chosen from the family of silicones.

7. Binding method according to any one of the preceding claims, **characterized in that** the substrate (102) is a fabric.

8. Binding method according to Claim 7, **characterized in that** the fabric is chosen from: a glass-fibre fabric, an aramid-fibre fabric and an aromatic-polyester fabric.

9. Binding method according to either one of Claims 7 and 8, **characterized in that** the weight per unit area of the fabric is between 20 g/m² and 300 g/m².

10. Binding method according to any one of Claims 1 to 9, **characterized in that** the rear faces (104) of the photovoltaic cells (101) are brought into contact with the impregnated portions (106) of the substrate (102) after the impregnation of the portions (106) of the substrate (102) with the crosslinkable polymer material (107).
